# EUROPÄISCHE PATENTSCHRIFT

(11) **EP 2 548 423 B1**
(45) Veröffentlichungstag und Bekanntmachung des Hinweises auf die Patenterteilung: **13.01.2016**
(21) Anmeldenummer: 11707683.6
(22) Anmeldetag: 11.03.2011
(51) Int. Cl.: H05K 1/16, H05K 3/20, H05K 5/00, H05K 3/00, H05K 3/46

(54) **SCHALTUNGSANORDNUNG UND ZUGEHÖRIGES STEUERGERÄT FÜR EIN KRAFTFAHRZEUG**
CIRCUIT ARRANGEMENT AND ASSOCIATED CONTROLLER FOR A MOTOR VEHICLE
CIRCUIT IMPRIMÉ ET APPAREIL DE COMMANDE CORRESPONDANT POUR VÉHICULE À MOTEUR

(30) Priorität: 17.03.2010 DE 102010002945
(43) Veröffentlichungstag der Anmeldung: 23.01.2013
(73) Patentinhaber: Robert Bosch GmbH, 70442 Stuttgart (DE)
(72) Erfinder: HEIM, Michael, 71088 Holzgerlingen (DE); KEIL, Stefan, 72127 Kusterdingen (DE); BRAUN, Gerhard, 72108 Rottenburg (DE); VOEGELE, Georg, 88085 Langenargen (DE)
(86) Internationale Anmeldenummer: PCT/EP2011/053735
(87) Internationale Veröffentlichungsnummer: WO 2011/113770

(56) Entgegenhaltungen:
- EP-A2- 0 740 365
- DE-A1- 4 102 349
- DE-A1-102008 018 199

## Beschreibung

### Stand der Technik

Die Erfindung geht aus von einer Schaltungsanordnung nach der Gattung des unabhängigen Patentanspruchs 1, und von einem Steuergerät für ein Kraftfahrzeug mit einer solchen Schaltungsanordnung.

Steuergeräte sind zur Steuerung verschiedenster Funktionen und Einrichtungen allgemein bekannt und werden im Automotive-Bereich in zunehmendem Maße zur Steuerung verschiedenster Funktionen eines Kraftfahrzeugs eingesetzt. Diese Steuergeräte gibt es in den unterschiedlichsten mechanischen Ausführungen. Üblicherweise umfasst ein Steuergerät mindestens eine Schaltungsanordnung mit einer elektrischen und/oder elektronischen Schaltungseinheit, welche einen Schaltungsträger, auf welchem mindestens ein elektrisches und/oder elektronisches Bauelement angeordnet ist, und mindestens einem Anschlussbereich mit mindestens einer Kontakteinheit zur elektrischen Kontaktierung der elektrischen und/oder elektronischen Schaltungseinheit mit anderen elektrischen und/oder elektronischen Baueinheiten, wie beispielsweise Stellelemente, Sensoren oder Stecker. Die Schaltungseinheit ist in der Regel innerhalb einer gegenüber der Umgebung abgedichteten Gehäuseeinheit angeordnet.

In der Offenlegungsschrift DE 10 2005 015 717 A1 wird beispielsweise eine elektrische Schaltungsanordnung, insbesondere für ein Kraftfahrzeug, und eine zugehöriges Steuergerät beschrieben. Die beschriebene elektrische Schaltungsanordnung umfasst einen Schaltungsträger mit elektrischen Schaltungselementen und eine der elektrischen Anbindung des Schaltungsträgers dienende Verbindungseinrichtung. Die Schaltungsanordnung ist in einem gegenüber einer Umgebung abgedichteten Gehäuse angeordnet, das ein Bodenelement und ein Deckelelement aufweist. Das Deckelelement ist über ein umlaufendes Dichtelement gegenüber dem Bodenelement abgedichtet. Zudem sind auf einem innerhalb des Gehäuses liegenden Bereich der Verbindungsanordnung elektrische Bauelemente angeordnet. Der beschriebene Schaltungsträger ist beispielsweise als keramischer Schaltungsträger, insbesondere als LTCC-Schaltungsträger (LTCC: Low Temperature Cofire Ceramic) ausgeführt und die beschriebene Verbindungseinheit ist beispielsweise als Leiterplatte, flexible Leiterplatte, flexible Folie oder als Stanzgitter ausgeführt.

In der Patentschrift US 7,514, 784 B2 wird eine elektronische Schaltungseinheit und ein korrespondierendes Herstellungsverfahren beschrieben. Die beschriebene Schaltungseinheit umfasst einen Schaltungsträger, auf welchem elektronische Bauelemente, Leiterbahnen und Metallanschlüsse zur elektrischen Kontaktierung des Schaltungsträgers angeordnet sind. Hierbei werden die elektronischen Bauelemente und die Leiterbahnen von einer Schutzmasse umgeben und die Metallanschlüsse zur elektrischen Kontaktierung sind außerhalb der Schutzmasse angeordnet. Die Metallanschlüsse zur Kontaktierung sind auf beiden Seiten des Schaltungsträgers angeordnet, wobei die einzelnen Metallanschlüsse nur an einer Oberfläche kontaktiert werden können.

In der Offenlegungsschrift DE 10 2008 018 199 A1 wird eine Schaltungsanordnung mit einer elektrischen und/oder elektronischen Schaltungseinheit beschrieben, welche einen Schaltungsträger, auf welchem mindestens ein elektrisches und/oder elektronisches Bauelement angeordnet ist, und mindestens einen Anschlussbereich mit mindestens einer Kontakteinheit zur elektrischen Kontaktierung der elektrischen und/oder elektronischen Schaltungseinheit mit anderen elektrischen und/oder elektronischen Baueinheiten umfasst. Der Schaltungsträger ist als mindestens ein Stanzgitterverbund mit einzelnen Leiterbahnen ausgeführt, welche in mindestens zwei verschiedenen Ebenen angeordnet sind.

Auch in den Dokumenten EP 0 740 365 A2 und DE 41 02 349 A1 wird jeweils eine Schaltungsanordnung mit einer elektrischen und/oder elektronischen Schaltungseinheit beschrieben, welche einen Schaltungsträger, auf welchem mindestens ein elektrisches und/oder elektronisches Bauelement angeordnet ist, und mindestens einen Anschlussbereich mit mindestens einer Kontakteinheit zur elektrischen Kontaktierung der elektrischen und/oder elektronischen Schaltungseinheit mit anderen elektrischen und/oder elektronischen Baueinheiten umfasst.

Der Schaltungsträger ist als mindestens ein Stanzgitterverbund mit einzelnen Leiterbahnen ausgeführt, welche in mindestens zwei verschiedenen Ebenen angeordnet sind.

### Offenbarung der Erfindung

Die erfindungsgemäße Schaltungsanordnung mit den Merkmalen des unabhängigen Patentanspruchs 1 hat demgegenüber den Vorteil, dass der Schaltungsträger als mindestens ein Stanzgitterverbund mit einzelnen Leiterbahnen ausgeführt ist, wobei die Leiterbahnen in mindestens zwei verschiedenen Ebenen angeordnet sind. Die elektrische und/oder elektronische Schaltungseinheit umfasst beispielsweise einen Schaltungsträger, auf welchem mindestens ein elektrisches und/oder elektronisches Bauelement angeordnet ist, und mindestens einen Anschlussbereich mit mindestens einer Kontakteinheit zur elektrischen Kontaktierung der elektrischen und/oder elektronischen Schaltungseinheit mit anderen elektrischen und/oder elektronischen Baueinheiten.

Die erfindungsgemäße Schaltungsanordnung kann beispielsweise in einem Steuergerät für ein Kraftfahrzeug eingesetzt werden, welches beispielsweise als Leistungsmodul zur Steuerung von elektrischen Antrieben aller Leistungsklassen, wie z.B. Lenkantriebe, Hybridfahrzeugantriebe, Elektrofahrzeugantriebe, Kleinmotoren wie Wischer, Fensterheber, Kühlwasserpumpen usw. zum Einsatz kommt. Außerdem sind Einsätze überall dort denkbar, wo elektronische Baugruppen für eine Weiterverarbeitung geschützt werden müssen.

Die in mindestens zwei verschiedenen Ebenen angeordneten Leiterbahnen sind erfindungsgemäß so konfiguriert, dass partielle Mehrlagigkeiten eine Kapazität ausbilden. Durch die ausgebildeten Kapazitäten können aus entstörungstechnischen bzw. schaltungstechnischen Gründen erforderliche diskrete Kondensatorbauelemente in vorteilhafter Weise ersetzt werden. Dadurch ist in vorteilhafter Weise auch die standardmäßige Kontaktierung der diskreten Kondensatorbauelemente mittels Lötmontage nicht mehr erforderlich. Somit werden Kondensatoren im Unterschied zum bisherigen Stand der Technik durch dreidimensionale Ausformung des Stanzgitterverbunds dargestellt. Der Stanzgitterverbund kann beispielsweise durch eine moldbare Klebefolie gehalten und/oder von einer

Schutzmasse umgeben werden. Die auf diese Weise entstehende partielle Mehrlagigkeit des Stanzgitterverbunds bzw. Schaltungsträgermaterials kann nun durch geeignete Geometrievorgabe erfindungsgemäß zusätzlich noch als (Platten-) Kondensator ausgebildet bzw. genutzt werden, welcher beispielsweise zur elektrischen Entstörung und/oder Stabilisierung einer Zwischenkreisspannung verwendet werden kann.

Die in mindestens zwei verschiedenen Ebenen angeordneten Leiterbahnen sind beispielsweise so konfiguriert, dass partielle Mehrlagigkeiten eine Leiterbahnüberkreuzung ausbilden. Dadurch können im Layout erforderliche Leiterbahnkreuzungen der Schaltungseinheit, welche durch die entsprechende Schaltung vorgegeben werden, ohne Einsatz von zusätzlichen Komponenten, wie Drahtbonds, Brücken usw., umgesetzt werden. Somit werden Leiterbahnkreuzungen und/oder Kondensatoren im Unterschied zum bisherigen Stand der Technik durch dreidimensionale Ausformung des Stanzgitterverbunds dargestellt. Der Stanzgitterverbund kann beispielsweise durch eine moldbare Klebefolie gehalten und/oder von einer Schutzmasse umgeben werden.

Durch die in den abhängigen Ansprüchen aufgeführten Maßnahmen und Weiterbildungen sind vorteilhafte Verbesserungen der im unabhängigen Patentanspruch 1 angegebenen Schaltungsanordnung möglich.

Besonders vorteilhaft ist, dass die Gehäuseeinheit eine Schutzmasse umfasst, welche die Schaltungseinheit abdichtend umgibt, und den mindestens einen Anschlussbereich so umgibt, dass die mindestens eine Kontakteinheit zumindest an ihren Seitenflächen in die Schutzmasse eingebettet ist. In einem sogenannten Moldprozess erhält die offene elektrische und/oder elektronische Schaltungseinheit durch die Schutzmasse bzw. Vergussmasse bzw. Moldmasse eine stabile Gehäuseform. Ausführungsformen der vorliegenden Erfindung erfüllen hierdurch zwei wesentliche Punkte, zum einen den Schutz des Schaltungsträgers und seiner Bauteile vor äußeren Einflüssen, wie beispielsweise Temperatur, Schmutz und/oder Wasser und zum anderen die Möglichkeit der direkten Kontaktierung des Schaltungsträgers mit anderen elektrischen Baueinheiten, wie beispielsweise einem Kabelbaum. Durch das bevorzugt durch Ummolden ausgeführte Umgeben des bestückten Schaltungsträgers mit der Schutzmasse können mehrere der sonst üblichen Fertigungsschritte entfallen, wodurch in vorteilhafter Weise Kosten eingespart werden können. Beim Ummolden wird der bestückte Schaltungsträger direkt mit einer als Kunststoff ausgeführten Schutzmasse, vorzugsweise mit einem Duroplast umspritzt bzw. vergossen, wodurch die sonst üblichen Gehäusebauteile, wie Gehäuseunterteil und Gehäuseoberteil, entfallen können. Damit verbunden entfallen in der Fertigung einige Montageschritte, wie beispielsweise das Zuführen der Gehäusebauteile, das Verschrauben des Schaltungsträgers im Gehäuseunterteil, das Aufbringen einer zwischen Gehäuseunterteil und Gehäuseoberteil wirkenden Dichtung, das Aufsetzen des Gehäuseoberteils auf das Gehäuseunterteil, das Verschrauben der beiden Gehäusebauteile miteinander. Insbesondere ergibt sich durch das zumindest seitliche Einbetten der Kontakteinheiten in die Schutzmasse bzw. Vergussmasse bzw. Moldmasse ein stabiler Anschlussbereich, welcher eine direkte Kontaktierung des Schaltungsträgers mit anderen elektrischen und/oder elektronischen Baueinheiten ermöglicht, welche einen korrespondierenden Gegenstecker aufweisen. So kann der Schaltungsträger über den Anschlussbereich und den zugehörigen Gegenstecker beispielsweise direkt mit einem Kabelbaum elektrisch verbunden werden. Vorteilhaft ist hierbei die Lösbarkeit der Verbindung zwischen dem Schaltungsträger und dem zugehörigen Gegenstecker bzw. der Verzicht auf den Einsatz von separaten Kontaktierverfahren, wie beispielsweise Herstellen von Schweiß-, Löt- oder Schneid-Klemmverbindungen usw. Außerdem können zusätzlich eingesetzte Kontaktiereinheiten, wie beispielsweise eine Messerleiste, entfallen. Hierdurch können in vorteilhafter Weise die Herstellungskosten für eine Schaltungsanordnung gesenkt werden und es entsteht eine kompakte, vergleichsweise kleine und gut gegenüber Umwelteinflüsse geschützte Schaltungsanordnung, welche in einem Kraftfahrzeugsteuergerät eingesetzt werden kann.

In vorteilhafter Ausgestaltung der erfindungsgemäßen Schaltungsanordnung ist der Schaltungsträger als mindestens ein Stanzgitterverbund mit einzelnen, bevorzugt innerhalb der Schutzmasse, angeordneten Leiterbahnen ausgeführt, wobei die mindestens eine Kontakteinheit als Kontaktzunge des als Stanzgitterverbund ausgeführten Schaltungsträgers ausgeführt ist, um eine Direktkontaktierung mit anderen elektrischen und/oder elektronischen Baueinheiten zu ermöglichen. Dazu werden die entsprechenden als Kontaktzungen ausgeführten Kontakteinheiten beispielsweise so ausgebildet, dass sie in einer Ebene bzw. Linie angeordnet sind und die vorhandenen Zwischenräume beim Moldprozess mit Moldmasse gefüllt sind. Durch eine mehrlagige Anordnung der einzelnen Leiterbahnen ist es auf einfachster Weise möglich, auch die Kontaktzungen der Kontakteinheit in mehr als einer Ebene anzuordnen. Alternativ können Kontaktzungen mehrerer Ebenen von Leiterbahnen auch durch Biegen der Stanzgitter in eine gleiche Ebenen zueinander gebracht werden. Ebenso können die in einer gemeinsamen Ebene vorgesehenen Kontaktzungen lateral zueinander versetzt, beispielsweise alternierend versetzt, angeordnet sein. Durch derartige Ausführungen der Kontaktzungen ist die Ausbildung einer Kontaktiereinheit zur Bildung einer mehrlagigen Steckverbindung ermöglicht.

In weiterer vorteilhafter Ausgestaltung der erfindungsgemäßen Schaltungsanordnung sind die Form und/oder Größe der mindestens einen Kontakteinheit an die mechanischen und/oder elektrischen Anforderungen, wie beispielsweise an die Stromtragfähigkeit angepasst. In weiterer vorteilhafter Ausgestaltung ist die mindestens eine Kontakteinheit auf der Oberseite und/oder Unterseite gleichzeitig kontaktierbar ausgeführt. Dadurch werden in vorteilhafter Weise Anwendungen mit hohen Strömen begünstigt.

In weiterer vorteilhafter Ausgestaltung der erfindungsgemäßen Schaltungsanordnung ist der Schaltungsträger zumindest teilweise auf einer thermisch leitenden Grundplatte angeordnet, welche zumindest teilweise von der Schutzmasse umgeben ist. Die thermisch leitende Grundplatte ist beispielsweise als Metallplatte mit einer aufgebrachten Isolierschicht ausgeführt. Zur Ausbildung eines Masseanschlusses kann die Isolierschicht eine Aussparung aufweisen. Die Isolierschicht kann beispielsweise durch Lackieren, Aufkleben einer Folie, Bedrucken, einen Belichtungsprozess, Eloxieren usw. vollständig oder partiell auf die thermisch leitende Grundplatte aufgetragen werden. Als thermische Grundplatte eignen sich insbesondere Strangpressprofile - beispielsweise aus Aluminium. Strangpressprofile erlauben eine längsgerichtete Ausführung einer Querschnittskontur, welche eine einfache und angepasste Montage der Schaltungsanordnung über das Strangpressprofil auf ein benachbartes Bauteil oder Baugruppe, beispielsweise ein zylindrisches Gehäuse eines Antriebsmotors, ermöglicht.

Durch die Integration der thermisch leitenden Grundplatte in die Schaltungsanordnung kann in vorteilhafter Weise eine optimale thermische Anbindung des Schaltungsträgers bzw. des Stanzgitterverbunds und ein stabiler Verbund mit der Gehäuseeinheit mit Schutzmasse erreicht werden. Hierbei wird die Isolierschicht so dünn wie möglich aufgebracht und kann gleichzeitig als Kleberschicht zur Befestigung des Schaltungsträgers bzw. Stanzgitterverbunds ausgeführt werden. Die Grundplatte übernimmt die Funktion eines Kühlkörpers. Zudem ermöglicht die integrierte thermisch leitende Grundplatte eine einfache Weiterführung des Wärmepfads auf einen weiteren Kühlkörper. So kann die Grundplatte beispielsweise durch Schweißen, Drücken, Bördeln, Kleben, Nieten usw. mit dem weiteren Kühlkörper verbunden werden. Die Schaltungsanordnung mit integrierter Grundplatte kann beispielsweise bei Anwendungen im Kraftfahrzeug eingesetzt werden, welche günstige Wärmeableitungseigenschaften erfordern. So kann die Schaltungsanordnung beispielsweise bei hoch integrierten Steuergerätebaugruppen für Xenonsteuergeräte verwendet werden.

Ausführungsbeispiele der Erfindung sind in den Zeichnungen dargestellt und werden in der nachfolgenden Beschreibung näher erläutert.

Kurze Beschreibung der Zeichnungen
Fig. 1 bis 3 zeigen jeweils eine schematische perspektivische Darstellung eines Ausschnitts eines als Stanzgitterverbund ausgeführten Schaltungsträgers für eine erfindungsgemäße Schaltungsanordnung.
Fig. 4 zeigt eine schematische perspektivische Darstellung eines ersten Ausführungsbeispiels einer erfindungsgemäßen Schaltungsanordnung.
Fig. 5 zeigt eine schematische Draufsicht auf das erste Ausführungsbeispiel der erfindungsgemäßen Schaltungsanordnung aus Fig. 4, wobei zur besseren Orientierung die Schutzmasse transparent dargestellt ist.
Fig. 6 zeigt eine Schnittdarstellung des ersten Ausführungsbeispiels der erfindungsgemäßen Schaltungsanordnung entlang der Schnittlinie VI-VI in Fig. 5 und eines Gegensteckers zur Kontaktierung der erfindungsgemäßen Schaltungsanordnung.
Fig. 7 zeigt eine Schnittdarstellung des ersten Ausführungsbeispiels der erfindungsgemäßen Schaltungsanordnung entlang der Schnittlinie VII-VII in Fig. 5.
Fig. 8 zeigt eine schematische perspektivische Darstellung einer thermisch leitenden Grundplatte für eine erfindungsgemäße Schaltungsanordnung.
Fig. 9 zeigt eine schematische perspektivische Darstellung der thermisch leitenden Grundplatte aus Fig. 8 mit aufgebrachtem Schaltungsträger, Anschlussbereich und elektrischen und/oder elektronischen Bauteilen.
Fig. 10 zeigt eine schematische perspektivische Darstellung eines zweiten Ausführungsbeispiels einer erfindungsgemäßen Schaltungsanordnung mit der thermisch leitenden Grundplatte aus Fig. 8.

### Ausführungsformen der Erfindung

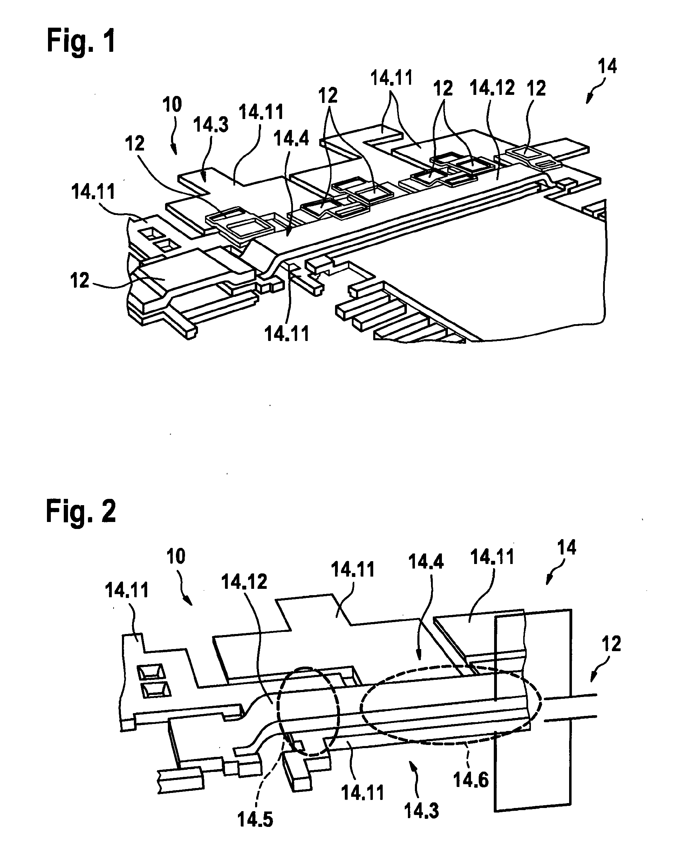

Wie aus Fig. 1 bis 3 ersichtlich ist, umfasst ein Schaltungsverbund 10 einen Schaltungsträger 14, welcher erfindungsgemäß als mindestens ein Stanzgitterverbund ausgeführt ist, auf dem mehrere elektrische und/oder elektronische Bauelemente 12 angeordnet sind. Zudem können die Leiterbahnen 14.11, 14.12 eines als Stanzgitter ausgeführten Schaltungsträgers 14 in mindestens zwei verschiedenen Ebenen 14.3, 14.4 angeordnet werden. Die in mindestens zwei verschiedenen Ebenen 14.3, 14.4 angeordneten Leiterbahnen 14.11,14.12 können beispielsweise so konfiguriert werden, dass partielle Mehrlagigkeiten eine Leiterbahnüberkreuzung 14.5 und/oder eine Kapazität 14.6 ausbilden. Der Stanzgitterverbund 14 kann beispielsweise durch eine moldbare Klebefolie 15 gehalten werden. Durch Ausführungsformen der Erfindung können durch Vorgaben der entsprechenden Schaltung im Layout notwendigen Leiterbahnkreuzungen 14.5 ohne Einsatz von zusätzlichen Komponenten, wie Drahtbonds, Brücken usw., umgesetzt werden. Durch die ausgebildeten Kapazitäten können aus entstörungstechnischen bzw. schaltungstechnischen Gründen erforderliche diskrete Kondensatorbauelemente 12 in vorteilhafter Weise ersetzt werden. Somit werden Leiterbahnkreuzungen und/oder Kondensatoren im Unterschied zum bisherigen Stand der Technik durch dreidimensionale Ausformung des Stanzgitterverbunds 14 dargestellt.

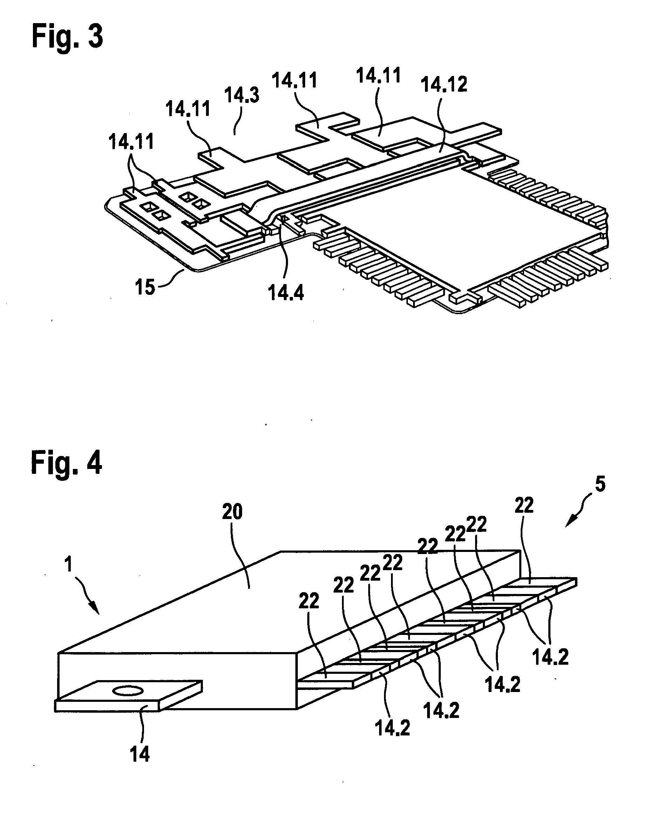

Fig. 4 bis 7 zeigen ein erstes Ausführungsbeispiel einer erfindungsgemäßen Schaltungsanordnung 1, welche eine elektrische und/oder elektronische Schaltungseinheit 10', die einen als Stanzgitterverbund ausgeführten Schaltungsträger 14', auf welchem mehrere elektrische und/oder elektronische Bauelemente 12 angeordnet sind, und einen Anschlussbereich 5 mit mehreren Kontakteinheiten 14.2 zur elektrischen Kontaktierung der elektrischen und/oder elektronischen Schaltungseinheit 10' mit anderen elektrischen und/oder elektronischen Baueinheiten 30 umfasst. Die Schaltungseinheit 10' ist in einer gegenüber der Umgebung abgedichteten Gehäuseeinheit 20 angeordnet, welche eine Schutzmasse umfasst, welche die Schaltungseinheit 10' abdichtend umgibt, und den Anschlussbereich 5 so umgibt, dass die Kontakteinheiten 14.2 zumindest an ihren Seitenflächen in die Schutzmasse 22 eingebettet sind.

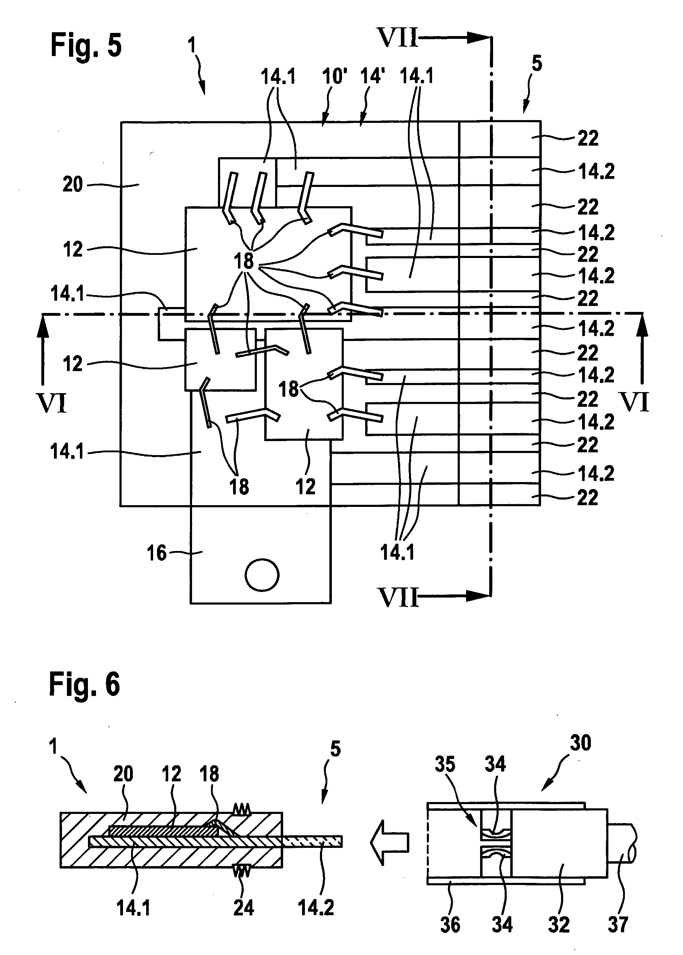

Wie aus Fig. 4 bis 7 weiter ersichtlich ist, sind die einzelnen Leiterbahnen 14.1 des als Stanzgitterverbund ausgeführten Schaltungsträgers 14' innerhalb der Schutzmasse 20 angeordnet. Hierbei sind die außerhalb der Schutzmasse 20 angeordneten Kontakteinheiten 14.2 als in einer Ebene liegende Kontaktzungen des als Stanzgitterverbund ausgeführten Schaltungsträgers 14' ausgeführt, um eine Direktkontaktierung mit den anderen elektrischen und/oder elektronischen Baueinheiten 30 zu ermöglichen. So können beispielsweise die Breite und die Dicke der Kontakteinheiten 14.2 unterschiedlich ausgeführt sein. Ebenso können die Kontakteinheiten 14.2 in unterschiedlichen Abständen zueinander angeordnet sein. Die vorhandenen Zwischenräume 22 zwischen den als Kontaktzungen ausgeführten Kontakteinheiten 14.2 werden beim Moldprozess ebenfalls mit Moldmasse gefüllt und geben dem Anschlussbereich 5 die erforderliche Stabilität und Festigkeit zur Umsetzung der Direktkontaktierung. Wie aus Fig. 5 oder 6 weiter ersichtlich ist, können die elektrischen und/oder elektronischen Bauelemente 12 über Verbindungselemente 18, die beispielsweise als Bonddrähte ausgeführt sind, untereinander und/oder mit den Leiterbahnen 14.1 des als Stanzgitterverbund ausgeführten Schaltungsträgers 14' elektrisch verbunden werden. Wie aus Fig. 4 oder 5 weiter ersichtlich ist, sind zwei elektrische und/oder elektronische Bauelemente 12 auf einer Leiterbahn 14.1 angeordnet, welche als Kühlelement 16 bzw. Kühlfahne aus der Schutzmasse 20 herausgeführt ist. Das Kühlelement 16 kann zur Ableitung von Verlustwärme mit einem nicht dargestellten Kühlkörper und/oder einem nicht dargestellten Massekontakt verbunden werden.

Wie aus Fig. 6 weiter ersichtlich ist, weist eine korrespondierende als Gegenstecker ausgeführte Kontaktiereinrichtung 30 zur Kontaktierung der Schaltungsanordnung 1 mit einem Kabelbaum 37 einen Anschlussbereich 35 und einen Kontaktträger 32 mit herausgeführten federelastischen Kontaktelementen 34 auf, wobei der Anschlussbereich 35 und der Kontaktträger 32 innerhalb eines Gehäuses 36 angeordnet sind. Zur Kontaktierung wird die Schaltungsanordnung 1 mit dem Anschlussbereich 5 in den Anschlussbereich 35 der Kontaktiereinrichtung 30 eingeführt, bis die federelastischen Kontaktelemente 34 auf den Oberflächen der Kontakteinheiten 14.2 aufliegen. Im dargestellten Ausführungsbeispiel werden die Kontakteinheiten 14.2 jeweils auf der Oberseite und Unterseite kontaktiert. Form und/oder Größe der Kontakteinheiten 14.2 sind an die mechanischen und/oder elektrischen Anforderungen angepasst. Eine umlaufende Radialdichtung 24 dichtet die Schutzmasse 20 gegen korrespondierende Innenflächen des Gehäuses 36 der Kontaktiereinrichtung 30 ab, um die elektrische Kontaktierung gegenüber Umwelteinflüssen und/oder Medien, wie beispielsweise Temperatur, Schmutz und/oder Wasser zu schützen.

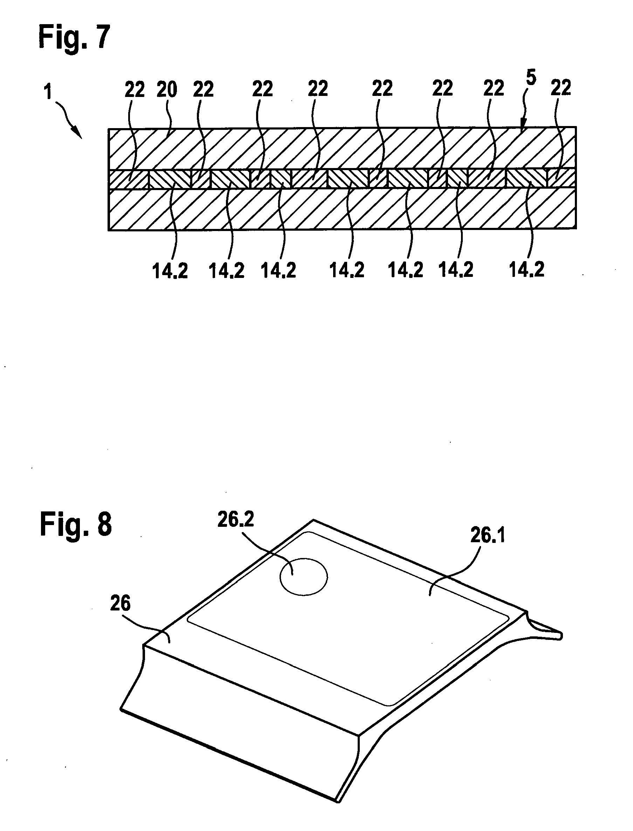

Wie aus Fig. 8 bis 10 ersichtlich ist, umfasst ein zweites Ausführungsbeispiel einer erfindungsgemäßen Schaltungsanordnung 1' eine elektrische und/oder elektronische Schaltungseinheit 10" und eine als Metallplatte ausgeführte thermisch leitende Grundplatte 26 mit einer aufgebrachten Isolierschicht 26.1. Die Isolierschicht 26.1 weist zur Ausbildung eines Masseanschlusses eine Aussparung 25.2 auf. Die elektrische und/oder elektronische Schaltungseinheit 10" umfasst analog zum ersten Ausführungsbeispiel einen als Stanzgitterverbund ausgeführten Schaltungsträger 14", auf welchem mehrere elektrische und/oder elektronische Bauelemente 12 angeordnet sind, und einen Anschlussbereich 5' mit mehreren Kontakteinheiten 14.2' zur elektrischen Kontaktierung der elektrischen und/oder elektronischen Schaltungseinheit 10" mit anderen elektrischen und/oder elektronischen Baueinheiten 30.

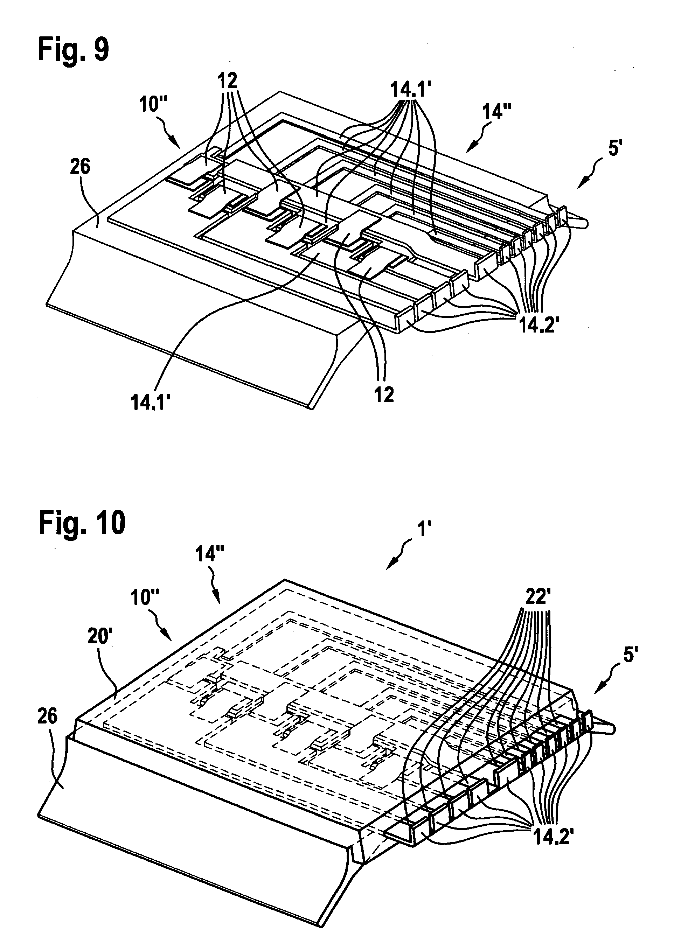

Wie aus Fig. 9 oder 10 ersichtlich ist, sind die einzelnen Leiterbahnen 14.1' des als Stanzgitterverbund ausgeführten Schaltungsträgers 14" analog zum ersten Ausführungsbeispiel innerhalb der Schutzmasse 20' angeordnet, auf welchen mehrere elektrische und/oder elektronische Bauelemente 12 angeordnet sind. Die Leiterbahnen 14.1' sind über die Isolierschicht 26.1 mit der thermisch leitenden Grundplatte 26 verbunden, wobei die Isolierschicht 26.1 selbst als Kleber ausgeführt sein kann. Analog zum ersten Ausführungsbeispiel sind die außerhalb der Schutzmasse 20' angeordneten Kontakteinheiten 14.2' ebenfalls als in einer Ebene liegende Kontaktzungen des als Stanzgitterverbund ausgeführten Schaltungsträgers 14' ausgeführt, um eine Direktkontaktierung mit den anderen elektrischen und/oder elektronischen Baueinheiten 30 zu ermöglichen. Die vorhandenen Zwischenräume 22' zwischen den als Kontaktzungen ausgeführten Kontakteinheiten 14.2' werden beim Moldprozess ebenfalls mit Moldmasse gefüllt und geben dem Anschlussbereich 5' die erforderliche Stabilität und Festigkeit zur Umsetzung der Direktkontaktierung.

Wie aus Fig. 10 weiter ersichtlich ist, ist die thermisch leitende Grundplatte 26 nicht vollständig von der Schutzmasse 20' umgeben. Dadurch ermöglicht die integrierte thermisch leitende Grundplatte 26 eine einfache Weiterführung des Wärmepfads auf einen nicht dargestellten Kühlkörper. So kann die Grundplatte 26 beispielsweise durch Schweißen, Drücken, Bördeln, Kleben, Nieten usw. mit dem Kühlkörper verbunden werden. Zudem können bei einem nicht dargestellten Ausführungsbeispiel auf einem nicht von der Schutzmasse 20' umgebenen Bereich der thermisch leitenden Grundplatte 26 verschiedenen elektrische und/oder elektronische Großbauteile oder Stecker angeordnet werden, welche nicht mit der Schutzmasse 20' umgeben werden sollen.

Durch die Integration der metallischen Grundplatte 26 in die Schaltungsanordnung 1' kann eine optimale thermische Anbindung der elektrischen und/oder elektronischen Bauelemente 12 über den Stanzgitterverbund 14" erfolgen. Zudem ergibt sich ein stabiler Verbund von Schaltungseinheit 10" und Grundplatte 26.

Die erfindungsgemäße Schaltungsanordnung kann beispielsweise in einem Steuergerät für ein Kraftfahrzeug eingesetzt werden, welches beispielsweise als Leistungsmodul zur Steuerung von elektrischen Antrieben aller Leistungsklassen, wie z.B. Lenkantriebe, Hybridfahrzeugantriebe, Elektrofahrzeugantriebe, Kleinmotoren wie Wischer, Fensterheber, Kühlwasserpumpen usw. zum Einsatz kommt. Außerdem sind Einsätze überall dort denkbar, wo elektronische Baugruppen für eine Weiterverarbeitung geschützt werden müssen.

## Patentansprüche

1. Schaltungsanordnung mit einer elektrischen und/oder elektronischen Schaltungseinheit (10, 10', 10"), welche einen Schaltungsträger (14, 14'), auf welchem mindestens ein elektrisches und/oder elektronisches Bauelement (12) angeordnet ist, und mindestens einen Anschlussbereich (5, 5') mit mindestens einer Kontakteinheit (14.2, 14.2') zur elektrischen Kontaktierung der elektrischen und/oder elektronischen Schaltungseinheit (10, 10', 10") mit anderen elektrischen und/oder elektronischen Baueinheiten (30) umfasst, wobei der Schaltungsträger (14, 14') als mindestens ein Stanzgitterverbund mit einzelnen Leiterbahnen (14.1, 14.1', 14.11, 14.12) ausgeführt ist, und wobei die Leiterbahnen (14.1, 14.1', 14.11, 14.12) in mindestens zwei verschiedenen Ebenen (14.3, 14.4) angeordnet sind, **dadurch gekennzeichnet, dass** die in mindestens zwei verschiedenen Ebenen (14.3, 14.4) angeordneten Leiterbahnen (14.1, 14.1', 14.11, 14.12) so konfiguriert sind, dass partielle Mehrlagigkeiten eine Kapazität (14.6) ausbilden, welche als Kondensator zur Entstörung und/oder Stabilisierung einer Zwischenkreisspannung verwendbar ist.

2. Schaltungsanordnung nach Anspruch 1, **dadurch gekennzeichnet, dass** die partiellen Mehrlagigkeiten eine Leiterbahnüberkreuzung (14.5) ausbilden.

3. Schaltungsanordnung nach Anspruch 1 oder 2, **dadurch gekennzeichnet, dass** die Schaltungseinheit (10, 10', 10") in einer gegenüber der Umgebung abgedichteten Gehäuseeinheit (20, 20') angeordnet ist, wobei die Gehäuseeinheit (20, 20') eine Schutzmasse umfasst, welche die Schaltungseinheit (10, 10') abdichtend umgibt, und den mindestens einen Anschlussbereich (5, 5') so umgibt, dass die mindestens eine Kontakteinheit (14.2, 14.2') zumindest an ihren Seitenflächen in die Schutzmasse (22, 22') eingebettet ist.

4. Schaltungsanordnung nach einem der Ansprüche 1 bis 3, **dadurch gekennzeichnet, dass** die mindestens eine Kontakteinheit (14.2, 14.2') als Kontaktzunge des als Stanzgitterverbund ausgeführten Schaltungsträgers (14, 14') ausgeführt ist, um eine Direktkontaktierung mit anderen elektrischen und/oder elektronischen Baueinheiten (30) zu ermöglichen.

5. Schaltungsanordnung nach einem der Ansprüche 1 bis 4, **dadurch gekennzeichnet, dass** die Form und/oder Größe der mindestens einen Kontakteinheit (14.2, 14.2') an die mechanischen und/oder elektrischen Anforderungen angepasst sind.

6. Schaltungsanordnung nach einem der Ansprüche 1 bis 5, **dadurch gekennzeichnet, dass** die mindestens eine Kontakteinheit (14.2, 14.2') auf der Oberseite und/oder Unterseite kontaktierbar ist.

7. Schaltungsanordnung nach einem der Ansprüche 1 bis 6, **dadurch gekennzeichnet, dass** der Schaltungsträger (14, 14') zumindest teilweise auf einer thermisch leitenden Grundplatte (26) angeordnet ist, welche zumindest teilweise von der Schutzmasse (20') umgeben ist.

8. Schaltungsanordnung nach Anspruch 7, **dadurch gekennzeichnet, dass** die thermisch leitenden Grundplatte (26) als Metallplatte mit einer aufgebrachten Isolierschicht (26.1) ausgeführt ist.

9. Schaltungsanordnung nach Anspruch 8, **dadurch gekennzeichnet, dass** die Isolierschicht (26.1) eine Aussparung (25.2) zur Ausbildung eines Masseanschlusses aufweist.

10. Steuergerät für ein Kraftfahrzeug **gekennzeichnet durch** eine Schaltungsanordnung nach einem der Ansprüche 1 bis 9.

## Claims

1. Circuit arrangement comprising an electrical and/or electronic circuit unit (10, 10', 10") which comprises a circuit carrier (14, 14'), on which at least one electrical and/or electronic component (12) is arranged, and at least one connection area (5, 5') with at least one contact unit (14.2. 14.2') for electrically contact-connecting the electrical and/or electronic circuit unit (10, 10', 10'') to other electrical and/or electronic structural units (30), wherein the circuit carrier (14, 14') is constructed as at least one lead frame assembly having individual conductor tracks (14.1, 14.1', 14.11, 14.12), and wherein the conductor tracks (14.1, 14.1', 14.11, 14.12) are arranged in at least two different planes (14.3, 14.4), **characterized in that** the conductor tracks (14.1, 14.1', 14.11, 14.12) arranged in at least two different planes (14.3, 14.4) are configured in such a manner that partial multi-layered arrangements form a capacitance (14.6) which can be used as a capacitor for interference suppression and/or stabilization of a link circuit voltage.

2. Circuit arrangement according to Claim 1, **characterized in that** the partial multi-layered arrangements form a conductor track cross-over (14.5).

3. Circuit arrangement according to Claim 1 or 2, **characterized in that** the circuit unit (10, 10', 10'') is arranged in a housing unit (20, 20') sealed against the environment, wherein the housing unit (20, 20') comprises a protective compound which surrounds the circuit unit (10, 10') in a sealing manner and surrounds the at least one connection area (5, 5') in such a manner that the at least one contact unit (14.2, 14.2') is embedded into the protective compound (22, 22') at least at its side faces.

4. Circuit arrangement according to one of Claims 1 to 3, **characterized in that** the at least one contact unit (14.2, 14.2') is constructed as contact blade of the circuit carrier (14, 14') constructed as lead frame assembly in order to provide for direct contact-connection to other electrical and/or electronic structural units (30).

5. Circuit arrangement according to one of Claims 1 to 4, **characterized in that** the shape and/or size of the at least one contact unit (14.2, 14.2') are matched to the mechanical and/or electrical requirements.

6. Circuit arrangement according to one of Claims 1 to 5, **characterized in that** the at least one contact unit (14.2, 14.2') is contact-connectable on the top and/or bottom.

7. Circuit arrangement according to one of Claims 1 to 6, **characterized in that** the circuit carrier (14, 14') is arranged at least partially on a thermally conductive baseplate (26) which is surrounded at least partially by the protective compound (20').

8. Circuit arrangement according to Claim 7, **characterized in that** the thermally conductive baseplate (26) is constructed as metal plate having an applied insulating layer (26.1).

9. Circuit arrangement according to claim 8, **characterized in that** the insulating layer (26.1) has a recess (25.2) for forming a ground connection.

10. Controller for a motor vehicle **characterized by** a circuit arrangement according to one of Claims 1 to 9.

## Revendications

1. Circuit comportant une unité de circuit électrique et/ou électronique (10, 10', 10") qui comprend un support de circuit (14, 14') sur lequel est disposé au moins un composant électrique et/ou électronique (12) et au moins une zone de connexion (5, 5') comportant au moins une unité de contact (14.2, 14.2') destinée à la mise en contact électrique de l'unité de circuit électrique et/ou électronique (10, 10', 10") avec d'autres modules électriques et/ou électroniques (30), dans lequel le support de circuit (14, 14') est réalisé sous la forme d'au moins une connexion de grille estampée avec des trajets conducteurs individuels (14.1, 14.1', 14.11, 14.12), et dans lequel les trajets conducteurs (14.1, 14.1', 14.11, 14.12) sont disposés dans au moins deux plans différents (14.3, 14.4), **caractérisé en ce que** les trajets conducteurs (14.1, 14.1', 14.11, 14.12) disposés dans au moins deux plans différents (14.3, 14.4) sont configurés de manière à ce que des caractères multicouches partiels forment une capacité (14.6) qui peut être utilisée en tant que condensateur pour l'antiparasitage et/ou la stabilisation d'une tension de circuit intermédiaire.

2. Circuit selon la revendication 1, **caractérisé en ce que** les caractères multicouches partiels forment un enjambement des trajets conducteurs (14.5).

3. Circuit selon la revendication 1 ou 2, **caractérisé en ce que** l'unité de circuit (10, 10', 10") est disposée dans une unité de boîtier (20, 20') hermétiquement isolée de l'environnement, dans lequel l'unité de boîtier (20, 20') comprend une masse de protection qui entoure de manière hermétique l'unité de circuit (10, 10'), et entoure l'au moins une zone de connexion (5, 5') de telle sorte que l'au moins une unité de contact (14.2, 14.2') soit incorporée au moins au niveau de ses surfaces latérales dans la masse de protection (22, 22').

4. Circuit selon l'une quelconque des revendications 1 à 3, **caractérisé en ce que** l'au moins une unité de contact (14.2, 14.2') est réalisée sous la forme de languettes de contact du support de circuit (14, 14') réalisé sous la forme d'une interconnexion de grille estampée afin de permettre une mise en contact directe avec d'autres modules (30) électriques et/ou électroniques.

5. Circuit selon l'une quelconque des revendications 1 à 4, **caractérisé en ce que** la forme et/ou la taille de l'au moins une unité de contact (14.2, 14.2') est/sont adaptée(s) aux exigences mécaniques et/ou électriques.

6. Circuit selon l'une quelconque des revendications 1 à 5, **caractérisé en ce que** l'au moins une unité de contact (14.2, 14.2') peut être mise en contact avec la face supérieure et/ou la face inférieure.

7. Circuit selon l'une quelconque des revendications 1 à 6, **caractérisé en ce que** le support de circuit (14, 14') est disposé au moins en partie sur une plaque de base thermiquement conductrice (26) qui est en outre au moins partiellement entourée par la masse de protection (20').

8. Circuit selon la revendication 7, **caractérisé en ce que** la plaque de base thermiquement conductrice (26) est réalisée sous la forme d'une plaque métallique sur laquelle est déposée une couche isolante (26.1).

9. Circuit selon la revendication 8, **caractérisé en ce que** la couche isolante (26.1) présente un évidement (25.2) destiné à former un raccord de masse.

10. Appareil de commande destiné à un véhicule à moteur, **caractérisé par** un circuit selon l'une quelconque des revendications 1 à 9.
